Europäisches Patentamt

European Patent Office

Office européen des brevets

(11) Publication number: **0 107 395**
**B1**

(12) **EUROPEAN PATENT SPECIFICATION**

(45) Date of publication of patent specification: **21.02.90**

(51) Int. Cl.⁵: **G 11 C 8/00, H 03 K 19/096**

(21) Application number: **83305879.5**

(22) Date of filing: **29.09.83**

(54) Decoder circuit.

(30) Priority: **29.09.82 JP 168273/82**

(43) Date of publication of application:
**02.05.84 Bulletin 84/18**

(45) Publication of the grant of the patent:
**21.02.90 Bulletin 90/08**

(84) Designated Contracting States:
**DE FR GB**

(56) References cited:
**GB-A-2 070 372**
**US-A-4 337 525**

**IBM TECHNICAL DISCLOSURE BULLETIN, vol.
17, no. 10, March 1975, pages 2835-2836, New
York, US; R.R. DESIMONE: "High-speed fet
decoder circuit"**

(73) Proprietor: **FUJITSU LIMITED
1015, Kamikodanaka Nakahara-ku
Kawasaki-shi Kanagawa 211 (JP)**

(72) Inventor: **Seki, Teruo
Dai-2-Yayoi-so 5 5-2 Shimoshinjo 3-chome
Nakahara-ku Kawasaki-shi Kanagawa 211 (JP)**
Inventor: **Yamauchi, Takahiko
Iseya-so 2F-1 49 Kitaya-cho
Nakahara-ku Kawasaki-shi Kanagawa 211 (JP)**
Inventor: **Aoyama, Keizo
11-28 Tsukimino 1-chome
Yamato-shi Kanagawa 242 (JP)**

(74) Representative: **Sunderland, James Harry et al
HASELTINE LAKE & CO Hazlitt House
28 Southampton Buildings Chancery Lane
London WC2A 1AT (GB)**

Courier Press, Leamington Spa, England.

**Description**

The present invention relates to a decoder circuit, more particularly to a decoder circuit preferably applied to a memory address decoder circuit fabricated in the form of a complementary metal oxide semiconductor (C-MOS).

As is well known, decoder circuits generally function to decode one digital signal and to transform it into another digital signal. In a semiconductor memory, decoder circuits decode memory addresses for selecting a desired word line and bit line to obtain access to the specific memory cell at the cross point therebetween. That is, in a semiconductor memory, decoder circuits are used as a word decoder circuits and column decoder (bit decoder) circuits.

In recent years, various new types of semiconductor memories have been proposed. Along with the advances made in semiconductor memories, various new types of word decoder and column decoder circuits with smaller size, higher density packaging or higher speed operation have been proposed.

Up until now, however, it has not been possible to achieve all three of these features in a decoder circuit simultaneously.

IBM Technical Disclosure Bulletin, Vol. 17, No. 10, March 1975, discloses a high-speed FET decoder circuit having a plurality of parallel-connected input transistors, each receiving a corresponding decoder input, and a node commonly connected to the outputs of the input transistors. A latch formed by a pair of crosscoupled transistors changes state in accordance with the voltage level at the node and provides an output signal. In operation, the node is first precharged to a given value, then, decode or address signals are applied to the input transistors.

US—A—4,337,525 discloses an integrated circuit including a detection circuit for detecting a change in logic input signal. The detection circuit may be employed in an internal clock signal generator involved in producing control signals used to control functional blocks of a memory device.

According to the present invention, there is provided a decoder circuit comprising:

a plurality of input transistors, each arranged to receive a corresponding decoder input as a control input, the input transistors being connected in parallel with each other;

a node commonly connected to the outputs of said input transistors; and

latch transistors for adopting a latched state in dependence upon the level at said node and for producing a decoder output; characterised by

a gate transistor arranged to receive a gate pulse as a control input, which is generated after every time a change of said decoder inputs takes place and operable to invert a level at said node momentarily by the gate pulse after said decoder inputs change from those specifying a nonselection state to those specifying a selection state;

and in that the latch transistors are operable to hold the level at the node as it is until the next change of the decoder input.

An embodiment of the present invention can provide a decoder circuit which can achieve smaller size, higher density packaging, and higher speed operation simultaneously.

This can be achieved by eliminating most of the series-connected transistors from the prior art decoder circuits. The series-connected transistors are replaced by the above-mentioned gate transistors and latch transistors.

The gate transistor functions to immediately invert a level at a certain node by a gate pulse, generated at every change of a decoder input, when the decoder input changes to one specifying a selection state. The latch transistors hold the level at the node as it is until the next change of the decoder input.

Reference is made, by way of example, to the accompanying drawings in which:

Fig. 1 is a circuit diagram of a first example of a prior art decoder circuit;

Fig. 2 is a circuit diagram of a second example of a prior art decoder circuit;

Fig. 3 is a circuit diagram of a third example of a prior art decoder circuit;

Fig. 4 is a circuit diagram of a decoder circuit according to a first embodiment of the present invention;

Fig. 5 depicts waveforms at major portions in Fig. 4 for explaining the operations of the circuit shown therein;

Fig. 6 is a circuit diagram of a decoder circuit according to a modified first embodiment of the present invention;

Fig. 7 is a circuit diagram of a decoder circuit according to a second embodiment of the present invention;

Fig. 8 is a circuit diagram of a decoder circuit according to a modified second embodiment of the present invention;

Figs. 9A and 9B are circuit diagrams representing an example for realizing a gate pulse generator;

Fig. 9C depicts waveforms of signals for explaining the operation of the circuit represented in Figs. 9A and 9B;

Fig. 10 illustrates a gate transistor shown in each of Figs. 4 and 6, which is further provided with a gate; and

Fig. 11 illustrates a gate transistor shown in each of Figs. 7 and 8, which is further provided with a gate.

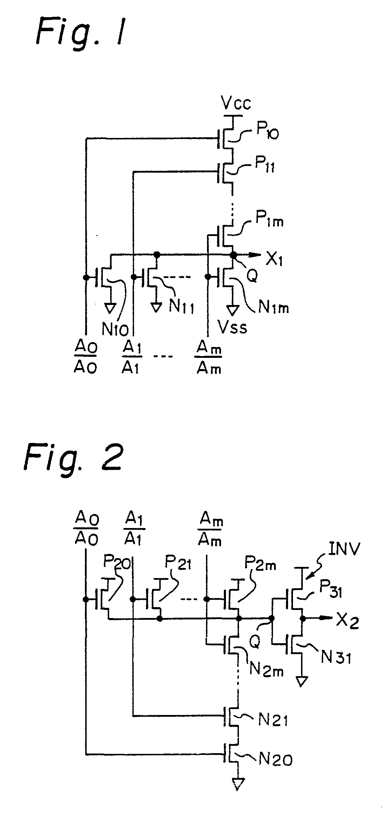

Figure 1 is a circuit diagram of a first example of a prior art decoder circuit. This type of decoder circuit is comprised of a plurality of input transistors and a plurality of series transistors. The input transistors receive, as control input, decoder inputs $A_0$, $\bar{A}_0$, $A_1$, $\bar{A}_1$, ... $A_m$, $\bar{A}_m$, (hereinafter referred to, as a whole, as $A_{in}$ for brevity) and are connected in parallel with each other. The series transistors also receive, as control inputs, decoder inputs $A_{in}$, but are connected in series with each other. Thus, a decoder output $X_1$ is

obtained at a node Q connected in common to each output of the parallel connected input transistors. In this arrangement, the input transistors are composed of N-channel transistors $N_{10}$, $N_{11}$ ... $N_{1m}$, while the series transistors are composed of P-channel transistors $P_{10}$, $P_{11}$ ... $P_{1m}$. The decoder inputs $A_{in}$ are expressed as a combination of ($A_0$ or $\overline{A}_0$), ($A_1$ or $\overline{A}_1$), ... ($A_m$, $\overline{A}_m$). If the inputs $A_{in}$ are all of logic L (low), the input transistors are all turned off, while the series transistors are all turned on. Thus, an "H" (high) level signal appears at the node Q. The decoder output $X_1$ is thereby changed to the "H" level so that a corresponding word line (not shown) receiving the "H" level output $X_1$ is selected. As seen from the above, the decoder circuit has a C-MOS structure.

The decoder circuit of Fig. 1 suffers from the problem that it requires twice the number of transistors (P-channel transistors and N-channel transistors) than the number (m+1) of bits of the decoder inputs $A_{in}$. This impedes size reduction amd high density packaging.

Also, the decoder circuit cannot achieve high speed operation due to the many series transistors ($P_{10}$, $P_{11}$ ... $P_{1m}$). The reason for this is, in brief, that a parasitic capacitor exists in each of the series-connected transistors. Assume the P-channel transistors $P_{10}$, $P_{11}$ ... $P_{1m}$ have all been off and are now all to be switched on so as to change the level at the node Q from "L" to "H". The node Q is not changed to the "H" level as quickly as intended until the parasitic capacitors, inherent to each P-channel transistor are sufficiently charged sequentially from $P_{10}$ to $P_{1m}$. Another reason for this is, in brief, that the effective conductance $g_m$ of the series-connected transistors is reduced. That is, assuming each of these series-connected transistors provides conductance $g_{mo}$, the effective conductance $g_m$ of the n series-connected transistors is reduced almost to $g_{mo}/n$.

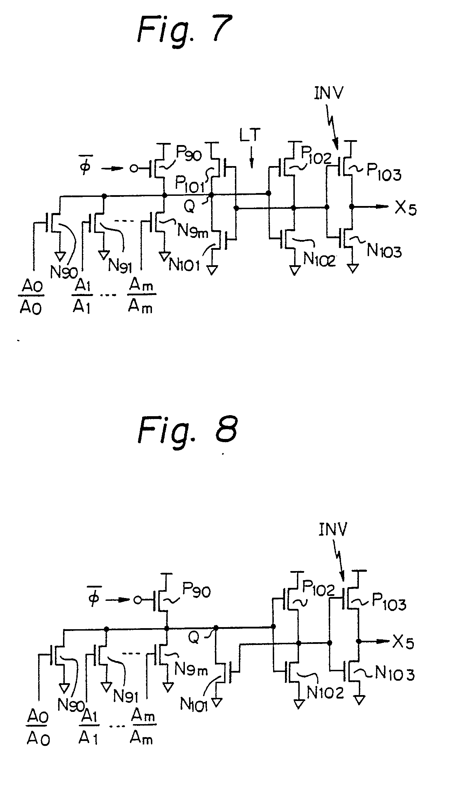

Figure 2 is a circuit diagram of a second example of a prior art decoder circuit. The prior art decoder circuit, known by, for example "2k×8 bit Hi-CMOS Static RAM's" IEEE J. Solid State Circuit, vol. sc-15 No. 4, P. 659, Fig. 8, is identical to that of Fig. 1, but has an inverted conductivity type channel of each corresponding transistor. The second example of the decoder circuit also has a C-MOS structure. In Figs. 1 to 3, identical members are represented by the same reference characters (and in later figures). Since the level at the node Q is opposite to that of the first type decoder circuit, an inverter INV, comprised of a P-channel transistor $P_{31}$ and an N-channel transistor $N_{31}$, is needed to obtain a decoder output $X_2$ of a desired level. This second type of decoder circuit suffers from the same size reduction and packaging density problem and operation speed problem as the first type.

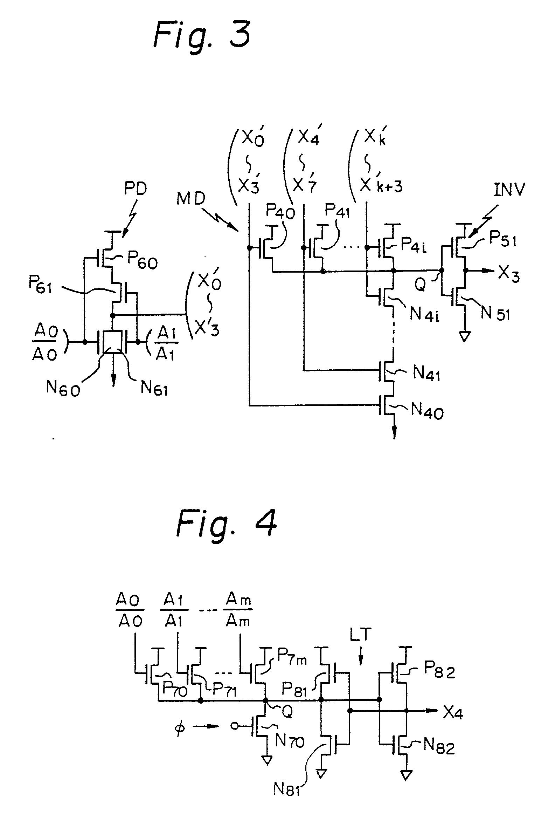

Figure 3 is a circuit diagram of a third example of a prior art decoder circuit. This type of decoder circuit is basically comprised of pre-decoder circuits PD (only one is illustrated for simplicity) and a main-decoder circuit MD. Pre-decoded outputs $X_0'$, ... $X_3'$ (and other pre-decoded outputs $X_4'$ ... $X_7'$, ... $X_k'$ ... $X_{k+3}'$) are first applied to the main-decoder circuit MD as decoder inputs therefor. Thus, a decoder output $X_3$ is produced. As shown the pre-decoder circuit PD is comprised of P-channel transistors $P_{60}$, $P_{61}$ and N-channel transistors $N_{60}$, $N_{61}$, while the main-decoder circuit MD is comprised of P-channel input transistors $P_{40}$, $P_{41}$, ... $P_{4i}$ and N-channel series transistors $N_{40}$, $N_{41}$ ... $N_{4i}$. The main-decoder circuit MD is further provided with an inverter INV comprised of a P-channel transistor $P_{51}$ and an N-channel transistor $N_{51}$. Therefore, the decoder circuit is similar to the second type.

This third type of decoder circuit can overcome the problem of size reduction and packaging density, since the total number of transistors is roughly halved. It still, however, suffers from the limited operational speed due to the inevitable time delay when the inputs pass through the pre-decoder circuits PD.

Figure 4 is a circuit diagram of a decoder circuit according to a first embodiment of the present invention. In Fig. 4, input transistors receiving, as control inputs, the decoder inputs $A_0$, $\overline{A}_0$, $A_1$, $\overline{A}_1$ ... $A_m$, $\overline{A}_m$ ($A_{in}$) are composed of P-channel transistors $P_{70}$, $P_{71}$ ... $P_{7m}$, which are connected in parallel with each other. The input transistors correspond to the input transistors ($P_{20}$, $P_{21}$ ... $P_{2m}$) of Fig. 2. Each output of these input transistors is connected in parallel with respect to a node Q. Further, P-channel transistors $P_{81}$, $P_{82}$ and N-channel transistors $N_{81}$, $N_{82}$ together form latch transistors LT.

It is important to note here that the series transistors shown in Figs. 1 through 3 are removed from the circuit of Fig. 4 and replaced with a new gate transistor (N-channel) $N_{70}$. In addition, the latch transistor LT is also newly employed. The elimination of the series transistors enables realization of size reduction, higher density packaging, and higher speed operation.

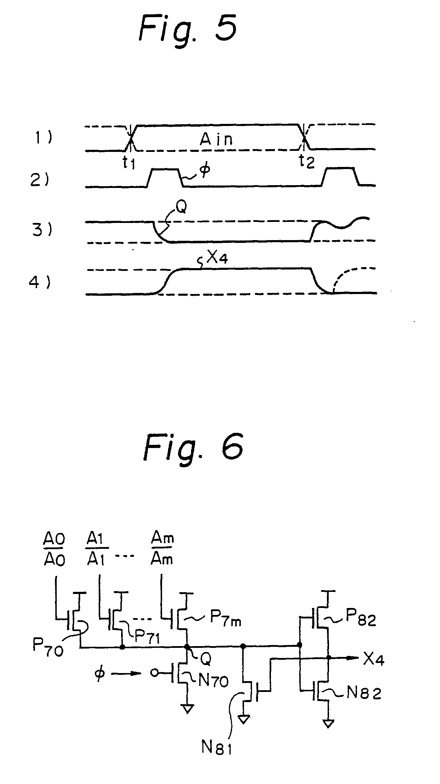

The operation of the first embodiment will be clarified below with reference to Fig. 5. Figure 5 depicts waveforms at major portions in Fig. 4. First, before the time $t_1$ (refer to row 1 of Fig. 5), the decoder inputs $A_{in}$ are left as they are, in which the decoder circuit is regarded to be, for example, in a nonselection state. In Fig. 5, the nonselection state and selection state are differentiated by broken lines and solid lines, respectively.

In the nonselection state, at least one of the decoder inputs $A_{in}$ should necessarily be a logic level of "L". Accordingly, the "H" level necessarily appears at the node Q. Due to the "H" level at the node Q, the transistor $N_{82}$ is turned on (the transistor $P_{82}$ is off), and thereby the decoder output $X_4$ of the "L" level is obtained. This "L" level is fed back to each gate of the transistors $P_{81}$ and $N_{81}$. Accordingly, the transistor $P_{81}$ is maintained on (transistor $N_{81}$ is off). As a result, a socalled latch state is established. That is, the latch transistors LT stably maintain the decoder output $X_4$ at the "L" level.

After the time $t_1$, suppose that the decoder input $A_{in}$ is then changed and thus the related decoder circuit is selected. In this case, at the time $t_1$, all the decoder inputs $A_{in}$ start changing to "H" levels. Just at that moment, a gate pulse $\phi$ is set at the "H" level for a short period. The gate pulse $\phi$ of the "H" level is applied to the gate transistor $N_{70}$ at its gate, thereby turning on the transistor $N_{70}$. At this moment, the level at the node Q is momentarily inverted from "H" to "L". It should be understood here that a deleterious power short cannot occur via the conductive gate transistor $N_{70}$, since the input transistors $P_{70}$, $P_{71}$ ... $P_{7m}$ are now all maintained off.

Thus, due to the "L" level at the node Q, the transistor $P_{82}$ is turned on (transistor $N_{82}$ is off) and the decoder output $X_4$ of the "H" level is produced. In this state, the "H" level of the decoder output $X_4$ is fed back to each gate of the transistors $P_{81}$ and $N_{81}$, and, accordingly, the transistor $N_{81}$ is maintained on (transistor $P_{81}$ is off). As a result, a latch state is established. That is, the latch transistors LT stably maintain the decoder output $X_4$ at the "H" level.

Assuming that the decoder input $A_{in}$ is then changed again at the time $t_2$, the decoder circuit is switched from the selection state to the nonselection state. In this state, at least one of the input transistors should necessarily be turned on, since at least one bit of the decoder inputs $A_{in}$ should necessarily be at the "L" level so that the level at the node Q is changed from "L" to "H". On the other hand, the gate pulse $\phi$ turns on the gate transistor $N_{70}$ for a short period, since the gate pulse $\phi$ is produced every time a change of the decoder inputs $A_{in}$ occurs. Due to the conductive gate transistor $N_{70}$, the level at the node Q momentarily falls to "L". However, since the gate pulse $\phi$ soon changes to the "L" level, the level at the node Q soon returns to "H" again. The thus restored "H" level state is equivalent to the state established before the time $t_1$, and thereby, the "L" level of the decoder output $X_4$ is stably maintained by means of the latch transistors LT.

During the term where the pulse $\phi$ is "H", the transistor $N_{70}$ is on, while at least one of the transistors $P_{70}$ to $P_{7m}$ of the remaining non-selected decoders is also on. Therefore, at this time, the level at the node Q is determined under a ratio between the $g_m$ of the transistor $N_{70}$, now on, and the $g_m$ of at least one, now on, of the transistors $P_{70}$ to $P_{7m}$. In actuality, the sizes of these transistors are so designed, in advance, as to prevent the decrease of the thus determined level at the node Q. Such design can also maintain the level substantially high at the node Q of each nonselected decoder.

Figure 6 is a circuit diagram of a decoder circuit according to a modified first embodiment of the present invention. In the modified embodiment of Fig. 6, the transistor $P_{81}$ of Fig. 4 is not used. The transistor $P_{81}$ may be omitted from the circuit arrangement of Fig. 4, since, when the decoder output $X_4$ is at the "H" level, only the transistor $N_{81}$ is on and, at the same time, the transistor $P_{81}$, now off, is not electrically effective. On the other hand, when the decoder output $X_4$ is at the "L" level, i.e., the decoder circuit is in the nonselection state, at least one of the transistors $P_{70}$, $P_{71}$ ... $P_{7m}$ is turned on, and, therefore, the at least one conductive transistor can substitute for the transistor $P_{81}$, now on.

However, there is an advantage in using the transistor $P_{81}$ in that it provides a noise-proofing ability.

Figure 7 is a circuit diagram of a decoder circuit according to a second embodiment of the present invention. The circuit structure of the second embodiment is equivalent to that of the first embodiment, but the conductivity type of each transistor is reversed. That is, a gate pulse $\bar{\phi}$ is used, instead of $\phi$, and the gate transistor is composed of a P-channel transistor $P_{90}$, instead of $N_{70}$. Further, the input transistors are composed of N-channel transistors $N_{90}$, $N_{91}$, ... $N_{9m}$, instead of $P_{70}$, $P_{71}$ ... $P_{7m}$, and, therefore, each levels of decoder inputs $A_{in}$ of the second embodiment is given as an inverted logic of the decoder inputs used in the first embodiment. Furthermore, the latch transistors LT are composed of P-channel transistors $P_{101}$, $P_{102}$ and N-channel transistors $N_{101}$, $N_{102}$, which are opposite in conductivity to those used in the first embodiment.

In this case, however, an inverter INV, comprised of a P-channel transistor $P_{103}$ and N-channel transistor $N_{103}$, must be employed, because the level at the node Q is also opposite to that produced in the first embodiment. That is, the output from the latch transistors LT must be inverted in level by means of the inverter INV so as to obtain a decoder output $X_5$ having predetermined levels, i.e., "H" in the selection state and "L" in the nonselection state.

The N-channel transistor $N_{101}$ can be removed from the circuit of Fig. 7, as previously stated regarding the transistor $P_{81}$ in the first embodiment, if no noise-proofing ability is required, as shown in Fig. 8.

In any of the above-mentioned embodiments, it is necessary to use a gate pulse $\phi$ ($\bar{\phi}$) generated every time a change of the decoder inputs $A_{in}$ occurs. In other words, an address change detecting circuit must be used with the decoder circuit of the present invention. The address change detecting circuit functions to detect level changes, i.e., "H"$\rightleftharpoons$"L", occurring in any one or more bits of the decoder inputs $A_{in}$ and is realized by utilizing a known similar circuit.

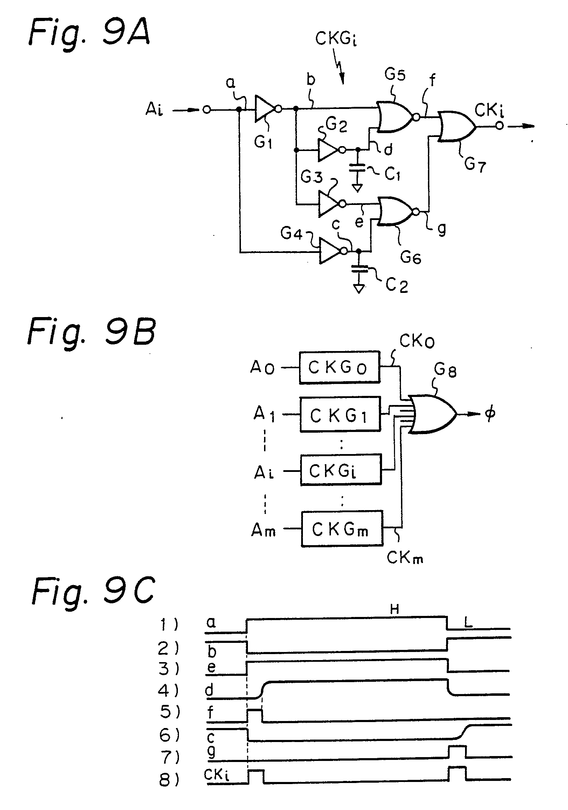

Figures 9A and 9B are circuit diagrams representing an example for realizing a gate pulse generator. The gate pulse generator is equivalent to the above-mentioned address change detecting circuit.

Figure 9C depicts waveforms of signals for explaining the operation of the circuit represented in Figs. 9A and 9B.

In Fig. 9A, the reference characters $G_1$ to $G_4$ denote inverters, $G_5$ and $G_6$ NOR gates, and $G_7$ an

OR gate. These members $G_1$ to $G_7$ are arranged, as shown. The thus arranged gate pulse generators $CKG_i$ receives a bit input $A_i$ of the decoder inputs $A_{in}$ and then produces a corresponding clock pulse $CK_i$. The gate pulse generators $CKG_i$ of Fig. 9A is allotted for the corresponding bit $A_i$ of the inputs $A_{in}$. Identical gate pulse generators $CKG_0$, $CKG_1$ ... $CKG_m$ are allotted for bits $A_0$, $A_1$ ... $A_m$ of the inputs $A_{in}$. The clock pulses $CK_0$ to $CK_m$ from generators $CKG_1$ through $CKG_m$ are ORed by means of an OR gate $G_8$, as shown in Fig. 9B.

With reference to Figs. 9A to 9C, when the bit $A_i$ of the inputs $A_{in}$ changes from the "L" level to "H" level as shown by a signal a in row 1) of Fig. 9C, the output from the inverter $G_1$ changes as shown by a signal b in row 2) thereof. (Signals a to g and $CK_i$ in Fig. 9C correspond to those shown in Figs. 9A and 9B). The output from the inverter $G_2$, receiving the signal b, is an output d (refer to row 4) of Fig. 9C) which is inverted in level and, simultaneously, delayed in time with respect to the signal b by means of a capacitor $C_1$. As a result, the output f (refer to row 5) of Fig. 9C) is produced from the NOR gate $G_5$, which output f is the clock pulse $CK_i$ to be generated at the leading edge of the related bit $A_i$.

The inverters $G_3$, $G_4$, a capacitor $C_2$, and the NOR gate $G_6$ operate in an identical manner to the operation mentioned above, however, the resultant output g (refer to row 7) of Fig. 9C) therefrom is generated not at the leading edge of the bit $A_i$ but at the trailing edge thereof.

These outputs f and g are ORed by means of the OR gate $G_7$, thus producing the clock pulse $CK_i$, which is a pulse obtained every time a bit change of $A_i$ occurs. Accordingly, the output from the OR gate $G_8$, ORing all the pulses $CK_0$ to $CK_m$, forms the intended gate pulse $\phi$, i.e., the gate pulse to be generated every time bit changes occur in any one or more bits of the decoder inputs $A_{in}$.

In the embodiments of Figs. 4, 6, 7, and 8, the gate transistor $N_{70}$ or $P_{90}$ is mounted to each of the word lines. Further, all the gate transistors in the same memory circuit are turned on simultaneously every time the decoder input change takes place, in which DC paths are unintentionally formed between a power source and a ground via respective conductive gate transistors. Although such DC paths are created during very short intervals i.e., the pulse width of the gate pulse ($\phi$, $\bar{\phi}$), this is not totally preferable in view of power consumption.

If a design requires that the number of the DC paths be as small as possible, a suitable gate may be added to and in series with each gate transistor, and opened only when the concerned word line is selected. For example, a semiconductor memory area is usually divided into a plurality of memory blocks. In this case, the gate is opened if the memory block including the concerned word line is activated.

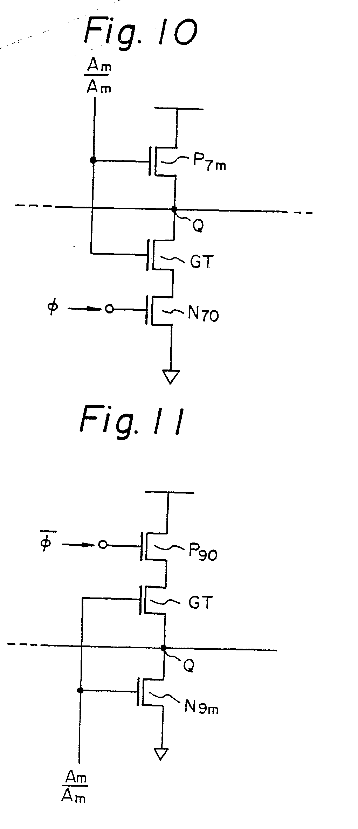

Figure 10 illustrates the gate transistor $N_{70}$ shown in each of Figs. 4 and 6, which is further provided with a gate. The gate GT is connected in series with the gate transistor $N_{70}$. Thus, the DC path is not created so long as the gate GT is closed. The gate GT is preferably controlled to open or close by the signal of the bit $A_m$ of the decoder inputs $A_{in}$. The logic "H" of the most significant bit (MSB) $A_m$ indicates that one half of the memory area is to be selected. Conversely, if logic "L", the MSB $A_m$ indicates that the other half thereof is to be selected. Accordingly, the power consumption due to the DC paths can be halved.

Figure 11 illustrates the gate transistor $P_{70}$ shown in each of Figs. 7 and 8, which is further provided with a gate. The gate GT in Fig. 11 is identical to that of Fig. 10.

The number of the DC paths can be minimized by utilizing the outputs from the pre-decoder circuits PD shown in Fig. 3, instead of the MSB $A_m$. Regarding the pre-decoded outputs ($X_0'$ to $X_2'$ (also for the outputs ($X_4'$ to $X_7'$) ... ($X_k'$ to $X_{k+3}'$)), the outputs $X_0'$ to $X_3'$ are applied to respective gates GT as on/off control signals. In this case, the gates GT are connected in series with the gate transistors receiving the pre-decoder outputs $X_0'$ to $X_{k+3}'$, respectively.

As explained above, the present invention allows realization of a decoder circuit with reduced size, higher density packaging, and higher speed operation. The above descriptions are made taking a case, as an example, where the decoder circuit is applied to the semiconductor memory, however, it should be understood that the decoder circuit of the present invention is not limited for such applications only.

## Claims

1. A decoder circuit comprising:
a plurality of input transistors ($P_{70}$ ... $P_{7m}$); $N_{90}$ ... $N_{9m}$), each arranged to receive a corresponding decoder input ($A_0$ ... $A_m$) as a control input, the input transistors being connected parallel with each other;
a node (Q) commonly connected to the outputs of said input transistors; and
latch transistors ($N_{81}$, $N_{82}$, $P_{81}$, $P_{82}$; $N_{101}$, $N_{102}$, $P_{101}$, $P_{102}$) for adopting a latched state in dependence upon the level at said node (Q) and for producing a decoder output ($X_4$; $X_5$); characterised by:
a gate transistor ($N_{70}$; $P_{90}$) arranged to receive a gate pulse ($\phi$; $\bar{\phi}$), as a control input, which is generated after every time a change of said decoder inputs ($A_0$ ... $A_m$) takes place, and operable to invert a level at said node (Q) momentarily by the gate pulse ($\phi$; $\bar{\phi}$) after said decoder inputs change from those specifying a nonselection state to those specifying a selection state; and in that the latch transistors ($N_{81}$, $N_{82}$, $P_{81}$, $P_{82}$; $N_{101}$, $N_{102}$, $P_{101}$, $P_{102}$) are operable to hold the level at the node (Q) as it is until the next change of the decoder inputs ($A_0$ ... $A_m$).

2. A decoder circuit as set forth in claim 1, wherein said input transistors ($P_{70}$ ... $P_{7m}$) are composed of first channel type transistors; said gate transistor ($N_{70}$) is composed of a second channel type transistor; and said gate pulse ($\phi$) has a first polarity.

3. A decoder circuit as set forth in claim 1, wherein said input transistors ($N_{90}$ ... $N_{9m}$) are composed of second channel type transistors; said gate transistor ($P_{90}$) is composed of a first channel type transistor; said gate pulse ($\bar{\phi}$) has a second polarity; and said latch transistors ($N_{101}$, $N_{102}$, $P_{101}$, $P_{102}$) are provided with, at their output side, an inverter ($N_{103}$, $P_{103}$).

4. A decoder circuit as set forth in claim 2, wherein said latch transistors are comprised of both a first C-MOS structure transistor pair ($N_{81}$, $P_{81}$) and a second C-MOS structure transistor pair ($N_{82}$, $P_{82}$), the output from the second C-MOS structure transistor pair being fed back to the input of the first C-MOS structure transistor pair, which output is produced as said decoder output ($X_4$).

5. A decoder circuit as set forth in claim 2, wherein said latch transistors are comprised of both a C-MOS structure transistor pair ($N_{82}$, $P_{82}$) producing said decoder output ($X_4$) and a second channel type transistor ($N_{81}$), the decoder output being branched to and fed back to the input of said second channel type transistor ($N_{81}$).

6. A decoder circuit as set forth in claim 3, wherein said latch transistors are comprised of both a first C-MOS structure transistor pair ($N_{101}$, $P_{101}$) and a second C-MOS structure transistor pair ($N_{102}$, $P_{102}$), the output from the second C-MOS structure transistor pair being, on one hand, fed back to the input of the first C-MOS structure transistor pair and, on the other hand, applied to the input of said inverter ($N_{103}$, $P_{103}$) so as to produce said decoder output ($X_5$) therefrom.

7. A decoder circuit as set forth in claim 3, wherein said latch transistors are comprised of both a C-MOS structure transistor pair ($N_{102}$, $P_{102}$) producing the output for said inverter and a second channel type transistor ($N_{101}$), which output from the C-MOS structure pair is branched to and fed back to the input of said second channel type transistor.

8. A decoder circuit as set forth in claim 2, 4 or 5, wherein said gate pulse ($\phi$) of the first polarity is produced by a gate pulse generator.

9. A decoder circuit as set forth in claim 3, 6, or 7, wherein said gate pulse ($\bar{\phi}$) of the second plurality is an inverted output of a gate pulse generator.

10. A decoder circuit as set forth in claim 8 or 9, wherein said gate pulse generator is fabricated as an address change detecting circuit which is operative to detect level changes occurring in any one or more bits of said decoder inputs ($A_0$ ... $A_m$).

11. A decoder circuit as set forth in claim 10, wherein a gate (GT) is further employed and connected in series with said gate transistor ($N_{70}$; $P_{90}$), which gate (GT) is made to open or close in accordance with the logic of the most significant bit ($A_m$) of the decoder inputs, or in accordance with the output of a predecoder (PD).

12. A decoder circuit as set forth in any preceding claim, further comprising a gate pulse generator mounted in the decoder circuit and operable to generate the gate pulse ($\phi$; $\bar{\phi}$).

13. A decoder as set forth in any preceding claim, wherein the decoder inputs ($A_0$ ... $A_m$) are arranged to be continuously supplied to the input transistors ($P_{70}$ ... $P_{7m}$); $N_{90}$... $N_{9m}$) in use.

14. A decoder as set forth in any preceding claim, wherein the input transistors ($P_{70}$ ... $P_{7m}$; $N_{90}$ ... $N_{9m}$) are designed with sizes such as to prevent a decrease in level at the node (Q) in use.

15. A decoder as set forth in any preceding claim, wherein the decoder circuit is arrangd to select a word line or a bit line in a semiconductor memory device by receiving address inputs ($A_0$ ... $A_m$) specifying the word or bit line to be selected.

**Patentansprüche**

1. Decoderschaltung mit:

einer Vielzahl von Eingangstransistoren ($P_{70}$ ... $P_{7m}$; $N_{90}$ ... $N_{9m}$), die jeweils angeordnet sind, um einen entsprechenden Decodereingang ($A_0$ ... $A_m$) als einen Kontrolleingang zu empfangen, wobei die Eingangstransistoren parallel zueinander verbunden sind;

einem Knoten (Q), der gemeinsam mit den Ausgängen der genannten Eingangstransistoren verbunden ist; und

Verriegelungstransistoren ($N_{81}$, $N_{82}$, $P_{81}$, $P_{82}$; $N_{101}$, $N_{102}$, $P_{101}$, $P_{102}$), um einen verriegelten Zustand anzunehmen, abhängig von dem Pegel bei dem genannten Knoten (Q), und um einen Decoderausgang ($X_4$; $X_5$) zu erzeugen; gekennzeichnet durch

einen Gatetransistor ($N_{70}$; $P_{90}$), der angeordnet ist, um einen Gateimpuls ($\phi$; $\bar{\phi}$) zu empfangen, als einen Steuereingang, welcher jedesmal erzeugt wird, wenn eine Änderung der genannten Decodereingänge ($A_0$ ... $A_m$) stattfindet, und betreibbar ist, um einen Pegel bei dem genannten Knoten (Q) momentan durch den Gateimpuls ($\phi$; $\bar{\phi}$) zu invertieren, nachdem die genannten Decodereingänge sich von jeden, die einen nichtausgewählten Zustand spezifizieren, zu jenen, die einen ausgewählten Zustand spezifizieren, ändern; und daß die Verriegelungstransistoren ($N_{81}$, $N_{82}$, $P_{81}$, $P_{82}$; $N_{101}$, $N_{102}$, $P_{101}$, $P_{102}$) betreibbar sind, um den Pegel bei dem Knoten (Q) bis zur nächsten Änderung der Decodereingänge ($A_0$ ... $A_m$) so zu halten, wie er ist.

2. Decoderschaltung nach Anspruch 1, bei der die genannten Eingangstransistoren ($P_{70}$ ... $P_{7m}$) aus Transistoren vom ersten Kanaltyp bestehen; der genannte Gatetransistor ($N_{70}$) aus einem Transistor von einem zweiten Kanaltyp besteht; und der Gateimpuls ($\phi$) eine erste Polarität hat.

3. Decoderschaltung nach Anspruch 1, bei der die genannten Eingangstransistoren ($N_{90}$... $N_{9m}$) aus Transistoren vom zweiten Kanaltyp bestehen, und der genannte Transistor ($P_{90}$) aus einem Transistor vom ersten Kanaltyp besteht; der genannte Gateimpuls ($\bar{\phi}$) eine zweite Polarität hat; und die genannten, Verriegelungstransistoren ($N_{101}$, $N_{102}$, $P_{101}$, $P_{102}$) an ihrer Ausgangsseite mit einem Inverter ($N_{103}$, $P_{103}$) versehen sind.

4. Decoderschaltung nach Anspruch 2, bei der die genannten Verriegelungstransistoren sowohl aus einem ersten Transistorpaar ($N_{81}$, $P_{81}$) von einer C-MOS-Struktur als auch von einem zweiten Transistorpaar ($N_{82}$, $P_{82}$) von einer C-MOS-Struktur bestehen, der Ausgang von dem zweiten C-MOS-Struktur-Transistorpaar zu dem Eingang des ersten C-MOS-Struktur-Transistorpaar zurückgeführt ist, welcher Ausgang als der genannte Decoderausgang ($X_4$) erzeugt wird.

5. Decoderschaltung nach Anspruch 2, bei der die genannten Verriegelungstransistoren sowohl aus einem C-MOS-Struktur-Transistorpaar ($N_{82}$, $P_{82}$), welches den genannten Decoderausgang ($X_4$) erzeugt, als auch aus einem Transistor ($N_{81}$) von einem zweiten Kanaltyp besteht, und der Decoderausgang verzweigt und zu dem Eingang des genannten Transistors ($N_{81}$) vom zweiten Kanaltyp zurückgeführt wird.

6. Decoderschaltung nach Anspruch 3, bei der die genannten Verriegelungstransistoren sowohl aus einem ersten C-MOS-Struktur-Transistorpaar ($N_{101}$, $P_{101}$) als auch aus einem zweiten C-MOS-Struktur-Transistorpaar ($N_{102}$, $P_{102}$) besteht, der Ausgang von dem zweiten C-MOS-Struktur-Transistorpaar einerseits zu dem Eingang des ersten C-MOS-Struktur-Transistorpaars zurückgeführt wird und andererseits dem genannten Inverter ($N_{103}$, $P_{103}$) zugeführt wird, um so von diesem den genannten Decoderausgang ($X_5$) zu erzeugen.

7. Decoderschaltung nach Anspruch 3, bei der die Verriegelungstransistoren sowohl aus einem C-MOS-Struktur-Transistorpaar ($N_{102}$, $P_{102}$), welches den Ausgang für den genannten Inverter erzeugt, als auch einen Transistor ($N_{101}$) von einem zweiten Kanaltyp bestehen, welcher Ausgang von dem C-MOS-Struktur-Paar verzweigt und zu dem Eingang des genannten Transistors vom zweiten Kanaltyp zurückgeführt ist.

8. Decoderschaltung nach Anspruch 2, 4 oder 5, bei der der genannte Gateimpuls ($\phi$) von der ersten Polarität durch einen Gateimpulsgenerator erzeugt wird.

9. Decoderschaltung nach Anspruch 3, 6 oder 7, bei der der genannte Gateimpuls ($\bar{\phi}$) der zweiten Vielzahl ein invertierter Ausgang eines Gateimpulsgenerators ist.

10. Decoderschaltung nach Anspruch 8 oder 9, bei der der genannte Gateimpulsgenerator als eine Adressenänderungs-Detektorschaltung hergestellt ist, die betreibbar ist, um Pegeländerungen zu detektieren, welche in irgendeinem oder mehreren Bits der genannten Decodereingänge ($A_0$ ... $A_m$) auftreten.

11. Decoderschaltung nach Anspruch 10, bei der ein Gate (GT) ferner verwendet und in Reihe mit dem genannten Gatetransistor ($N_{70}$; $P_{90}$) verbunden ist, welches Gate (GT) ausgebildet ist, um in Übereinstimmung mit der Logik des höchstwertigen Bit ($A_m$) der Decodereingänge, oder in Übereinstimmung mit dem Ausgang eines Vordecoders (PD), zu öffnen oder zu schließen.

12. Decoderschaltung nach einem der vorhergehenden Ansprüche, ferner mit einem Gateimpulsgenerator, der auf der Decoderschaltung montiert und betreibbar ist, um einen Gateimpuls ($\phi$; $\bar{\phi}$) zu erzeugen.

13. Decoderschaltung nach einem der vorhergehenden Ansprüche, bei der die Decodereingänge ($A_0$ ... $A_m$) angeordnet sind, um kontinuierlich den benutzten Eingangstransistoren ($P_{70}$ ... $P_{7m}$; $N_{90}$ ... $P_{9m}$) zugeführt zu werden.

14. Decoder nach einem der vorhergehenden Ansprüche, bei dem die Eingangstransistoren ($P_{70}$ ... $P_{7m}$; $N_{90}$ ... $N_{9m}$) mit solchen Größen ausgelegt sind, daß sie einen Abfall des Pegels an dem Knoten (Q) im Betrieb verhindern.

15. Decoder nach einem der vorhergehenden Ansprüche, bei dem die Decoderschaltung angeordnet ist, um eine Wortleitung oder eine Bitleitung in einer Halbleiterspeichervorrichtung durch Empfang von Adressen ($A_0$ ... $A_m$), die die auszuwählende Wort- oder Bitleitung spezifizieren, auszuwählen.

**Revendications**

1. Circuit décodeur comprenant:
un ensemble de transistors d'entrée ($P_{70}$, ...., $P_{7m}$; $N_{90}$, ..., $N_{9m}$), disposés chacun pour recevoir un signal d'entrée de décodeur correspondant ($A_0$, ..., $A_m$) comme signal de commande d'entrée, les transistors d'entrée étant connectés en parallèle entre eux;
un noeud (Q) connecté en commun aux sorties des transistors d'entrée; et
des transistors de verrouillage ($N_{81}$, $N_{82}$, $P_{81}$, $P_{82}$; $N_{101}$, $N_{102}$, $P_{101}$, $P_{102}$) pour adopter un état verrouillé selon le niveau au noeud (Q) et pour produire un signal de sortie de décodeur ($X_4$; $X_5$); caractérisé par:
un transistor de déclenchement ($N_{70}$; $P_{90}$) agencé pour recevoir une impulsion de déclenchement ($\phi$; $\bar{\phi}$), comme signal de commande d'entrée, qui est engendrée après chaque fois où un changement des signaux d'entrée de décodeur ($A_0$, ..., $A_m$) a lieu, et pouvant être mis en fonctionnement pour inverser un niveau au noeud (Q) temporairement par l'impulsion de déclenchement ($\phi$; $\bar{\phi}$) après que les signaux d'entrée de décodeur changent de ceux spécifiant un état de non sélection à ceux spécifiant un état de sélection; et en ce que les transistors de verrouillage ($N_{81}$, $N_{82}$, $P_{81}$, $P_{82}$; $N_{101}$, $N_{102}$, $P_{101}$, $P_{102}$) peuvent être mis en fonctionnement pour maintenir le niveau au noeud (Q) comme il est jusqu'au changement suivant des signaux d'entrée de décodeur ($A_0$, ..., $A_m$).

2. Circuit décodeur selon la revendication 1, dans lequel les transistors d'entrée ($P_{70}$, ..., $P_{7m}$) sont constitués de transistors à premier type de canal; le transistor de déclenchement ($N_{70}$) est constitué d'un transistor à second type de canal; et l'impulsion de déclenchement ($\phi$) a une première polarité.

3. Circuit décodeur selon la revendication 1, dans lequel les transistors d'entrée ($N_{90}$, ..., $N_{9m}$) sont constitués de transistors à second type de canal; le transistor de déclenchement ($P_{90}$) est constitué d'un transistor à premier type de canal:

l'impulsion de déclenchement ($\bar{\phi}$) a une seconde polarité; et les transistors de verrouillage ($N_{101}$, $N_{102}$, $P_{101}$, $P_{102}$) sont pourvus, du côté de leur sortie, d'un inverseur ($N_{103}$, $P_{103}$).

4. Circuit décodeur selon la revendication 2, dans lequel les transistors de verrouillage sont constitués à la fois d'une première paire de transistors à structure à métal-oxyde-semiconducteur à symétrie complémentaire C-MOS ($N_{81}$, $P_{81}$) et d'une deuxième paire de transistors à structure C-MOS ($N_{82}$, $P_{82}$), le signal de sortie de la deuxième paire de transistors à structure C-MOS étant renvoyé à l'entrée de la première paire de transistors à structure C-MOS, ce signal de sortie étant produit comme signal de sortie de décodeur ($X_4$).

5. Circuit décodeur selon la revendication 2, dans lequel les transistors de verrouillage sont constitués à la fois d'une paire de transistors à structure C-MOS ($N_{82}$, $P_{82}$) produisant le signal de sortie de décodeur ($X_4$) et d'un transistor à second type de canal ($N_{81}$), le signal de sortie de décodeur étant dérivé et renvoyé à l'entrée du transistor à second type de canal ($N_{81}$).

6. Circuit décodeur selon la revendication 3, dans lequel les transistors de verrouillage sont constitués à la fois d'une première paire de transistors à structure C-MOS ($N_{101}$, $P_{101}$) et d'une deuxième paire de transistors à structure C-MOS ($N_{102}$, $P_{102}$), le signal de sortie de la deuxième paire de transistors à structure C-MOS étant, d'une part, renvoyé à l'entrée de la première paire de transistors à structure C-MOS et, d'autre part, appliqué à l'entrée de l'inverseur ($N_{103}$, $P_{103}$) de manière à produire le signal de sortie de décodeur ($X_5$) à partir de celui-ci.

7. Circuit décodeur selon la revendication 3, dans lequel les transistors de verrouillage sont constitués à la fois d'une paire de transistors à structure C-MOS ($N_{102}$, $P_{102}$) produisant le signal de sortie pour l'inverseur et d'un transistor à second type de canal ($N_{101}$), le signal de sortie de le paire de transistors à structure C-MOS étant dérivé vers et renvoyé à l'entrée du transistor à second type de canal.

8. Circuit décodeur selon l'une quelconque des revendications 2, 4 et 5, dans lequel l'impulsion de déclenchement ($\phi$) de la première polarité est produite par un générateur d'impulsions de déclenchement.

9. Circuit décodeur selon l'une quelconque des revendications 3, 6 et 7, dans lequel l'impulsion de déclemchement ($\bar{\phi}$) du deuxième ensemble est un signal de sortie inversé d'un générateur d'impulsions de déclenchement.

10. Circuit décodeur selon l'une quelconque des revendications 8 et 9, dans lequel le générateur d'impulsions de déclenchement fabriqué comme un circuit de déection de changement d'adresse qui est actif pour détecter des changements de niveau se produisant dans un ou plusieurs bits des signaux d'entrée de décodeur ($A_0$, ..., $A_m$).

11. Circuit décodeur selon la revendication 10, dans lequel une porte (GT) est en outre mise en oeuvre et connectée en série avec le transistor de déclenchement ($N_{70}$; $P_{90}$), cette porte (GT) étant ouverte ou fermée selon le niveau logique du bit de poids le plus fort ($A_m$) des signaux d'entrée de décodeur, ou selon le signal de sortie d'un prédécodeur (PD).

12. Circuit décodeur selon l'une quelconque des revendications 1 à 11, comprenant en outre un générateur d'impulsions de déclenchement monté dans le circuit décodeur et pouvant être mis en fonctionnement pour engendrer l'impulsion de déclenchement ($\phi$; $\bar{\phi}$).

13. Décodeur selon l'une quelconque des revendications 1 à 12, dans lequel les signaux d'entrée de décodeur ($A_0$, ..., $A_m$) sont agencés pour être fournis en continu aux transistors d'entrée $P_{70}$, ..., $P_{7m}$; $N_{90}$, ..., $N_{9m}$) en fonctionnement.

14. Décodeur selon l'une quelconque des revendications 1 à 13, dans lequel les transistors d'entrée ($P_{70}$, ..., $P_{7m}$; $N_{90}$, ..., $N_{9m}$) sont conçus avec des dimensions telles qu'elles empêchent une diminution de niveau au noeud (Q) en fonctionnement.

15. Décodeur selon l'une quelconque des revendications 1 à 14, dans lequel le circuit décodeur est agencé pour sélectionner un fil de mot ou un fil de bit dans un dispositif de mémoire à semiconducteur en recevant les signaux d'entrée d'adresse ($A_0$, ..., $A_m$) spécifiant le fil de mot ou le fil de bit à sélectionner.

# Fig. 1

# Fig. 2

## Fig. 3

## Fig. 4

# Fig. 5

1)  Ain   t1   t2

2)  φ

3)  Q

4)  X4

# Fig. 6

$\overline{A0}$/A0   $\overline{A1}$/A1   ···   $\overline{Am}$/Am

P70   P71   P7m   P82

φ → N70   Q   N81   N82   X4

## Fig. 7

## Fig. 8

**Fig. 9A**

**Fig. 9B**

**Fig. 9C**

# Fig. 10

# Fig. 11